# EUROPÄISCHE PATENTSCHRIFT

(11) **EP 3 040 245 B1**
(45) Veröffentlichungstag und Bekanntmachung des Hinweises auf die Patenterteilung: **25.09.2019**
(21) Anmeldenummer: 15198448.1
(22) Anmeldetag: 08.12.2015
(51) Int. Cl.: B60R 16/037, B60N 2/02, G06F 3/0484, G06F 3/0488, H03K 17/96, G06F 3/044, G06F 3/01, B60K 37/06, B60K 35/00

(54) **VORRICHTUNG UND VERFAHREN ZUR UNTERSTÜTZUNG EINES ANWENDERS VOR EINER BEDIENUNG EINES SCHALTERS ZUR ELEKTROMOTORISCHEN VERSTELLUNG EINES TEILS EINES FORTBEWEGUNGSMITTELS**
DEVICE AND METHOD FOR SUPPORTING A USER BEFORE OPERATION OF A SWITCH FOR ELECTROMOTIVE ADJUSTMENT OF A PART OF A MEANS OF LOCOMOTION
DISPOSITIF ET PROCEDE D'ASSISTANCE A UN UTILISATEUR LORS D'UNE COMMANDE D'UN CONNECTEUR DESTINEE AU REGLAGE PAR MOTEUR ELECTRIQUE D'UNE PARTIE D'UN MOYEN DE LOCOMOTION

(30) Priorität: 02.01.2015 DE 102015200006
(43) Veröffentlichungstag der Anmeldung: 06.07.2016
(73) Patentinhaber: Volkswagen AG, 38440 Wolfsburg (DE)
(72) Erfinder: WILD, Holger, 10179 Berlin (DE); KÖTTER, Nils, 38126 Braunschweig (DE)
(74) Vertreter: Hoefer & Partner Patentanwälte mbB

(56) Entgegenhaltungen:
- EP-A1- 1 228 917
- DE-A1- 10 342 666
- DE-A1-102006 003 174
- DE-A1-102009 007 707
- DE-A1-102009 026 902
- DE-A1-102012 216 181
- JP-A- 2009 269 528
- US-A1- 2014 309 871
- US-B1- 6 774 505

## Beschreibung

### Stand der Technik

Die vorliegende Erfindung betrifft ein Fortbewegungsmittel, eine Vorrichtung sowie ein Verfahren zur Unterstützung eines Anwenders vor einer Bedienung eines Schalters zur elektromotorischen Verstellung eines Teils eines Fortbewegungsmittels. Insbesondere betrifft die vorliegende Erfindung eine Ausgabe von Hinweisen an einen Anwender, wenn er sich an den Schalter eines Bedienelementes zur Anpassung einer Sitzfunktion annähert. Moderne Innenräume von Kraftfahrzeugen weisen eine zunehmende Vielzahl von Anpassungsmöglichkeiten auf. Beispiele hierfür sind die Bedienelemente der elektrischen Sitzverstellung, welche sich bei Fahrzeugen mitunter an der Sitzkonsole (Verkleidung der Sitz-Basiseinheit) befinden. Bei geschlossenen Türen sind diese Bedienelemente nicht einsehbar und durch den geringen Platz zwischen der Tür und dem Sitz (bzw. seiner Sitzkonsole) schwierig zu bedienen. Mitunter befinden sich die Sitzbedienelemente auch in den Türen (z. B. in der Nähe der Türöffner). Auch sind Sitzbedienelemente in der Mittelkonsole, in der Nähe der Feststellbremse, bekannt, womit sie für die Fahrzeuginsassen sichtbar sind. Der Bauraum in den Türen ist durch Türöffner, Zuziehgriff, Schalter für elektrische Fensterhebel und Spiegel, Lautsprecher etc. stark eingeschränkt. Der Bauraum in der Mittelkonsole ist durch den Gangwahlhebel, Cupholder, Ablagefächer, Schalter für Fahrwerkseinstellungen und die Feststellbremse stark eingeschränkt. Zudem ist eine Schalterflut schnell verwirrend und wird aus ästhetischen Gründen nicht erwünscht.

DE 10 2005 054 171 A1 offenbart ein Verfahren zur Überwachung motorisch betriebener Fahrzeugkomponenten, bei welchem eine Annäherung an eine Taste zum Zwecke eines Einklemmschutzes (beispielsweise im Zuge einer Bedienung eines Schiebedaches eines Fahrzeugs) erkannt wird.

DE 10 2011 018 378 A1 offenbart eine Vorrichtung zur Positionierung eines Elements in einem Kraftfahrzeug, bei welchem ein Näherungssensor zur Erkennung eines bestimmten Annäherungsmusters an das Element vorgesehen ist. Auf diese Weise können Positionierungsbefehle für das Element ohne ein Vorhandensein mechanischer Schalter erfasst werden. Auch zur Einstellung eines Sitzteils sind Annäherungssensoren offenbart, welche der Anwender durch ein Streichen mit der Hand über das entsprechende Sitzteil bedient.

WO 2007/121977 A2 offenbart ein Steuersystem für ein Fahrzeugcockpit, bei welchem durch ein Bildschirmmenü, durch Erkennung von Anwendergesten an einem Lenkrad navigiert werden kann. Dabei wird vorgeschlagen, eine erfolgte Sitzverstellung am Display zu visualisieren.

DE 103 42 666 A1 offenbart ein Bediensystem für ein Fahrzeug, bei welchem ein manuelles Betätigungsmittel mit einer Annäherungsfunktion ausgestattet ist. Im Ansprechen auf eine Annäherung des Anwenders an das Betätigungsmittel wird auf einer Anzeigeeinheit eine dem manuellen Betätigungsmittel zugeordnete Bedienfunktion dargestellt, wodurch die Bedienfunktion zusätzlich über die Anzeigeeinheit bedienbar ist.

JP 2009 269 528 A offenbart eine Sitzgelegenheit für ein Fortbewegungsmittel mit einer Bedienknopfanordnung auf einer Sitzflächenverkleidung. Ein kapazitiver Sensor in den Bedienelementen kann einen Annäherung des Anwenders ermitteln, im Ansprechen auf welche eine derzeit ausgeführte Sitzfunktion dem Anwender auf einer Anzeigeeinheit veranschaulicht wird.

DE 10 2009 007 707 A1 offenbart eine Bedienvorrichtung zur Steuerung elektrisch verstellbarer Komponenten, innerhalb welcher Bedienelemente mit kapazitiven, induktiven oder resistiven Messtechniken eine Aktion des Bedieners (z.B. Annäherung an die Bedieneinheit oder ein Berühren der Bedieneinheit) detektieren. Im Ansprechen auf die Annäherung der Hand kann eine hinter dem Bedienelement angeordnete Leuchtquelle ein- bzw. ausgeschaltet werden oder ihre Farbgestaltung beeinflusst werden.

EP 1 228 917 A1 offenbart eine Steuervorrichtung für ein Fortbewegungsmittel, bei welchem eine Annäherung von einer Berührung unterschieden und durch unterschiedliche Rückmeldungen an den Anwender quittiert werden. Die Rückmeldung kann beispielsweise über ein Head-Up-Display erfolgen.

DE 10 2006 003 174 A1 offenbart ein Bedienelement für ein Fortbewegungsmittel, bei welchem im Ansprechen auf die Annäherung eines Körperteils eine aus dem Bedienelement ausgeschüttete Lichtfarbe oder -intensität variiert wird.

US 6 774 505 B1 offenbart eine Schalteranordnung für ein Fortbewegungsmittel mit annäherungsbedingter Beleuchtung.

US 2014/309871 A1 und DE 10 2012 216 181 A1 offenbaren Systeme zur gestenbasierten Einstellung eines Fahrzeugsitzes durch einen Benutzer.

Die vorstehend identifizierten Gegenstände des Standes der Technik schöpfen die technischen Möglichkeiten zur Unterstützung eines Anwenders im Rahmen einer Bedienung einer Fahrzeugfunktion nur unvollständig aus.

Es ist daher eine Aufgabe der vorliegenden Erfindung, den vorstehend identifizierten Bedarf zu bedienen bzw. zu befriedigen.

### Offenbarung der Erfindung

Die vorstehend identifizierte Aufgabe wird erfindungsgemäß durch ein Verfahren gemäß Anspruch 1, eine Vorrichtung gemäß Anspruch 6 und ein Fortbewegungsmittel gemäß Unteranspruch 12 gelöst. Hierzu wird zunächst eine Annäherung des Anwenders (z. B. seiner Hand) an einen ersten Schalter des Fortbewegungsmittels erkannt. Als "Annäherung" sei im Rahmen der vorliegenden Erfindung eine Präsenz eines Eingabemittels in einem zum Schalter nahegelegenen Bereich ohne Kontakt zum Schalter verstanden. Als Schalter wird im Rahmen der vorliegenden Erfindung eine elektromechanische Bedieneinrichtung zur Steuerung elektromotorisch verstellbarer Teile des Fortbewegungsmittels verstanden. Insbesondere umfasst der Schalter dabei einen reversibel (z.B. galvanisch) schließbaren elektrischen Kontakt. Insbesondere ist ein Schalter im Rahmen der vorliegenden Erfindung nicht als kapazitive Eingabeoberfläche zu verstehen.

In einem zweiten Schritt wird ein Hinweis zu einer dem ersten Schalter zugeordneten Funktion angezeigt. Der Hinweis kann beispielsweise auf einem zentralen Informationsdisplay und/oder einem Kombiinstrument angezeigt werden. Alternativ kann der Hinweis als Lichtzeichen/Leuchtsymbol durch ein am Schalter selbst angeordnetes Leuchtmittel ausgegeben werden, nachdem eine vordefinierte Annäherung des Anwenders an den Schalter erkannt worden ist. Bereits vor der Bedienung des Schalters (bzw. vor dem Öffnen/Schließen des vom Schalter zu beeinflussenden elektrischen Kontaktes) wird der Anwender über die Möglichkeiten der Verstellung des Teils informiert. Auf diese Weise wird ein Nachteil optisch für den Anwender schlecht einsehbarer Bedieneinheiten aus bedienergonomischer Sicht gelindert. Insbesondere können mechanische Schalter optisch aus dem Fokus der Insassen gerückt werden, wodurch die Fahrgastzelle aufgeräumter erscheint und sich Anwender besser orientieren können.

Die Unteransprüche zeigen bevorzugte Weiterbildungen der Erfindung.

Die Funktion kann beispielsweise eine Sitzverstellung und/oder eine Spiegelverstellung und/oder eine Schiebedachverstellung oder eine Verstellung eines Sonnenrollos sein. Wie eingangs ausgeführt, können am Beispiel einer Sitzverstellung ein erster Schalter oder eine Ansammlung erster Schalter zur Anpassung der Sitzposition im Bereich (z.B. an einer Konsole) des Fahrzeugsitzes angeordnet sein. Entsprechendes gilt für die anderen vorgenannten Funktionsvarianten. Je nachdem, über welchen der ersten Schalter der Anwender streicht bzw. welchem ersten Schalter er sich annähert, kann ein anderer Hinweis auf dem Bildschirm ausgegeben werden. Beispielsweise kann eine mittels des jeweiligen ersten Schalters elektromotorisch verstellbare Komponente des Teils optisch veranschaulicht und insbesondere in einer Übersicht mehrerer Komponenten des Teils hervorgehoben werden. Auf diese Weise kann der Anwender eine optische Rückmeldung darüber erhalten, auf welche Komponente sich eine Bedienung des Schalters auswirkt und welche Auswirkung eine tatsächliche Bedienung des Schalters haben wird bzw. hätte. Anpassungen der Sitzposition können somit gezielter erfolgen und irrige Bedienschritte, welche die Bordelektrik unnötig belasten und verschleißfördernd sind, können vermieden werden.

Erfindungsgemäß wird eine unter Kontakt mit einer Oberfläche des Schalters und/oder in einem Erfassungsbereich vor dem Schalter ausgeführte Anwendergeste erfasst und erkannt. Hierfür kommen z.B. kapazitive und/oder optische und/oder ultraschallbasierte Sensoren in Frage. Im Ansprechen auf die erkannte Anwendergeste kann ein der Eingabe zugeordneter Steuerbefehl an einen Elektromotor zur Verstellung des Teils ausgegeben werden. Der Steuerbefehl kann die elektromotorische Verstellung des Teils des Fortbewegungsmittels in einer Art bzw. eine Richtung vornehmen, welche der erkannten Anwendergeste zugeordnet ist.

Der Hinweis kann beispielsweise eine Abbildung eines Sitzes umfassen, in welcher die getrennt voneinander bedienbaren Elemente als solche optisch gegeneinander abgegrenzt sind. Alternativ oder zusätzlich kann eine dem Schalter zugeordnete Funktion des Teils kenntlich gemacht werden. Dieses kann eine Animation und/oder eine anderweitige Darstellung möglicher Positionen des Teils umfassen. Insbesondere kann der Teil, auf welchen sich die Funktion des angenäherten Schalters bezieht, optisch hervorgehoben, insbesondere vergrößert und/oder farblich gekennzeichnet werden. Dieses schließt nicht aus, dass zeitgleich mehrere Schalter angenähert, bedient und im angezeigten Hinweis entsprechend berücksichtigt (z.B. hervorgehoben und/oder animiert) werden könnten.

Sobald der Hinweis auf dem Bildschirm angezeigt wird, kann eine Eingabe eines Anwenders bezüglich des Hinweises durch eine hierfür vorgesehene Erfassungseinrichtung (z. B. ein Touchscreen, eine Annäherungssensorik o. ä.) erfasst werden und ein zur Eingabe korrespondierender Steuerbefehl an einen Elektromotor zur Verstellung des Teils ausgegeben werden. Mit anderen Worten kann der Hinweis eine Bildschirmdarstellung umfassend Schaltflächen aufweisen, sodass der Anwender allein durch die Annäherung an die Schalter (z. B. beispielsweise an der Sitzkonsole) eine softwaretechnische Steuerung der Sitzposition vornehmen kann. Bekanntlich bieten Bildschirme mit berührungsempfindlicher Oberfläche deutlich umfangreichere und mitunter komfortablere Bedienmöglichkeiten zur Eingabe von Befehlen. Gegenüber einer dauerhaften Bedienung des ersten Schalters zur allmählichen Sitzverstellung kann ein Anwender auf dem Bildschirm bzw. mittels einer Annäherungssensorik, bevorzugt auch unter Verwendung von 3D-Gesten, welche frei im Raum ausgeführt und sensorisch erfasst werden, wahlfrei Sitzpositionen kennzeichnen, welche anschließend vollautomatisch realisiert werden, ohne dass der Anwender hierzu dauerhaft eine entsprechende Eingabe tätigen muss. Insbesondere für ein Aufrufen zuvor abgespeicherter Sitzpositionen besteht nun die Möglichkeit, durch eine punktuelle Eingabe (z. B. auf einer zuvor definierten Schaltfläche) eine Sitzposition abzurufen, sich unverzüglich wieder der Fahraufgabe zu widmen und die Bordelektrik des Fortbewegungsmittels den Rest erledigen zu lassen. Anstatt zunächst mittels eines universellen Bedienelementes ein Menü zur Anpassung einer Sitzposition aufzurufen, kann der Anwender durch eine bloße Annäherung an den ersten Schalter den vorstehend beschriebenen Menüpunkt zur Anpassung der Sitzposition aufrufen, rasch und komfortabel eine gewünschte Sitzposition definieren und den Auswahlvorgang binnen Sekundenbruchteilen beenden, wodurch die volle Aufmerksamkeit des Fahrers nur entsprechend kurz anteilig von der Wahrnehmung der Fahraufgabe abgelenkt ist.

Gemäß einem zweiten Aspekt der vorliegenden Erfindung wird eine Vorrichtung zur Unterstützung eines Anwenders vor einer Bedienung eines Schalters zur elektromotorischen Verstellung eines Teils eines Fortbewegungsmittels vorgeschlagen. Die Vorrichtung umfasst einen ersten Schalter, welcher zur elektromotorischen Verstellung eines ersten Teils des Fortbewegungsmittels vorgesehen ist. Eine erste Annäherungssensorik ist eingerichtet, eine Annäherung des Anwenders an den ersten Schalter zu erkennen. Insbesondere kann die Annäherungssensorik innerhalb des ersten Schalters angeordnet sein. Solche Sensoren können beispielsweise kapazitive Sensoren umfassen. Im Ansprechen auf die Annäherung wird ein Signal zum Anzeigen eines Hinweises zu einer dem ersten Schalter zugeordneten Funktion (z.B. auf einem Bildschirm des Fortbewegungsmittels) gesendet. Mit anderen Worten kann die Annäherungssensorik im Ansprechen auf die Annäherung des Anwenders das Aufrufen eines den Hinweis umfassenden Bildschirminhaltes veranlassen. Alternativ oder zusätzlich kann der Hinweis als Lichtzeichen/Leuchtsymbol durch ein am Schalter selbst angeordnetes Leuchtmittel ausgegeben werden. Hierzu kann die Vorrichtung eine Blende mit einem transluzenten Piktogramm aufweisen und das Leuchtmittel hinter der Blende angeordnet sein. Ein Lichtleiter kann zur Vermittlung zwischen dem Leuchtmittel und der Blende angeordnet sein und als Diffusor ausgestaltet für eine homogene Lichtausschüttung sorgen. Auf diese Weise wird der Anwender darüber informiert, welche Funktionalität eine Bedienung des seiner Hand nahe gelegenen Schalters haben wird.

Zusätzlich kann ein zweiter Schalter zur elektromotorischen Verstellung eines zweiten Teils des Fortbewegungsmittels vorgesehen sein. Der zweite Schalter kann beispielsweise einer Rückenlehne eines Sitzes zugeordnet sein, während der erste Schalter die Position der Sitzfläche des Sitzes verändert. Eine zweite Annäherungssensorik ist eingerichtet, eine Annäherung eines Anwenders an den zweiten Schalter zu erkennen. Dieses kann insbesondere unabhängig von einer Annäherung des Anwenders an den ersten Schalter erfolgen. Im Ansprechen darauf wird ein Signal zum Anzeigen eines Hinweises zu einer dem zweiten Schalter zugeordneten Funktion (z.B. auf dem Bildschirm des Fortbewegungsmittels oder gemäß einer in Verbindung mit dem ersten Schalter diskutierten Alternative) gesendet. Mit anderen Worten veranlasst eine Annäherung an den zweiten Schalter das Aufrufen eines Hinweises, welcher sich auf die dem zweiten Schalter zugeordnete Funktion, also einer elektromotorischen Verstellung des zweiten Teils, bezieht. Wie vorstehend beschrieben, kann der Hinweis auch in diesem Zusammenhang eine Schaltfläche oder mehrere Schaltflächen auf weisen, mittels welcher der Anwender noch komfortabler und bevorzugt wahlfrei einzelne Positionen für das Teil anwählen kann.

Erfindungsgemäß umfasst die Vorrichtung eine Eingabeeinrichtung zur Erkennung einer unter Kontakt mit einer Oberfläche des ersten Schalters und/oder in einem Erfassungsbereich vor dem ersten Schalter ausgeführten Anwendergeste. Weiter ist eine Auswerteeinheit vorgesehen, welche eingerichtet ist, im Ansprechen auf eine vordefinierte Anwendergeste einen der Eingabe zugeordneten Steuerbefehl an einen Elektromotor zur Verstellung des Teils auszugeben. Die Eingabeeinrichtung kann beispielsweise kapazitiv, optisch oder unter Verwendung von Ultraschall die Hand des Anwenders, ihre Position, ihre Ausrichtung bis hin zu angewinkelten oder gestreckten Fingern erfassen und in elektrische Signale wandeln, welche von der Auswerteeinheit verarbeitet werden können, so dass bereit vor einer Bedienung des Schalters eine elektromotorische Verstellung eines Teils des Fortbewegungsmittels erfolgen kann. Zudem können durch die Gestenerkennung Schaltflächen und sogar Schalter erübrigt werden, so dass die Zahl in Hardware ausgeführter Schalter in der Vorrichtung reduziert werden bzw. ihr Funktionsumfang bei gleicher Schalteranzahl erhöht werden kann. Weiter kann die Vorrichtung ein Leuchtmittel und eine über dem ersten Schalter oder neben dem ersten Schalter angeordnete Blende umfassen, wobei die Blende einen in Form eines Piktogramms geformten transluzenten Bereich aufweist und das Leuchtmittel eingerichtet ist, im Ansprechen auf ein Steuersignal der ersten Annäherungssensorik Licht durch die Blende auszuschütten. Die Blende kann beispielsweise als Lackschicht auf der Unterseite einer ansonsten transluzenten Abdeckung ausgestaltet sein, wobei das Piktogramm als Gravur oder durch Maskierung eines entsprechenden Bereiches während der Lackierung hergestellt sein kann.

Die Vorrichtung kann bevorzugt eine dem Bildschirm zugeordnete berührungsempfindliche Oberfläche umfassen, welche eingerichtet ist, im Ansprechen auf eine Betätigung eines auf dem Bildschirm dargestellten Bedienelementes, einen Steuerbefehl zur Herstellung einer mit dem Steuerbefehl korrespondierenden Position des Teils zu veranlassen. Mit anderen Worten ist der Hinweis eingerichtet, Anwendereingaben bezüglich vordefinierter Sitzpositionen zu empfangen und anschließend eine vollautomatische Herstellung der korrespondierenden Position des Teils zu veranlassen. Eine andauernde Bedienung eines ersten oder zweiten Schalters bzw. einer den Schaltern zugeordneten Schaltfläche auf der berührungsempfindlichen Oberfläche kann entfallen, wodurch das Ablenkungspotential des Bedienvorgangs minimiert wird.

Die Annäherungssensorik kann einen kapazitiven Sensor und/oder einen optischen Sensor und/oder einen Ultraschallsensor umfassen. Durch die vorgenannten Wirkprinzipien kann die Sensorik robust, klein und kostengünstig ausgeführt werden. Insbesondere für kapazitive Sensoren und Ultraschallsensoren ist eine Fehlfunktion aufgrund von Verschmutzungen nicht zu befürchten. Der optische Sensor kann beispielsweise als Kamera (2D-/3D-Kamera) ausgestaltet sein, welche den Innenraum des Fortbewegungsmittels überwacht. Wird eine Hand bzw. ein anderes Körperteil des Anwenders im Bereich des ersten Schalters oder des zweiten Schalters erkannt, veranlasst die Kamera bzw. eine Bildauswerteeinheit (welche eine Objekt- und/oder Kantenerkennung auszuführen imstande ist) die Ausgabe des erfindungsgemäß vorgesehenen Hinweises. Auf diese Weise können unterschiedliche Schalter im Innenraum durch lediglich einen Sensor hinsichtlich einer Annäherung des Anwenders überwacht werden.

Gemäß einem dritten Aspekt der vorliegenden Erfindung wird ein Fortbewegungsmittel vorgeschlagen, welches eine Vorrichtung zur Unterstützung eines Anwenders vor einer Bedienung eines Schalters zur elektromotorischen Verstellung eines Teils eines Fortbewegungsmittels gemäß dem zweitgenannten Erfindungsaspekt umfasst. Die Merkmale, Merkmalskombinationen und die sich aus diesen ergebenden Vorteile entsprechen dem in Verbindung mit dem zweitgenannten Erfindungsaspekt Ausgeführten derart ersichtlich, dass zur Vermeidung von Wiederholungen auf die obigen Ausführungen verwiesen wird.

### Kurze Beschreibung der Zeichnungen

Nachfolgend werden Ausführungsbeispiele der Erfindung unter Bezugnahme auf die begleitenden Zeichnungen im Detail beschrieben. In den Zeichnungen ist:
- Figur 1: eine perspektivische Ansicht eines ausgestalteten Fahrzeuginnenraums bei einer Bedienung erster Schalter durch die Hand eines Anwenders;
- Figur 2: eine Ansicht eines Bildschirms vor einer erkannten Annäherung an die in Figur 1 dargestellten ersten Schalter;
- Figur 3: eine Ansicht eines Bildschirms nach einer erkannten Annäherung an die in Figur 1 dargestellten ersten Schalter;
- Figur 4: eine Veranschaulichung eines Hinweises, umfassend einen Schieberegler zur wahlfreien Anpassung einer Position einer Sitzlehne;
- Figur 5: ein Flussdiagramm veranschaulichend Schritte eines Ausführungsbeispiels eines erfindungsgemäßen Verfahrens;
- Figur 6: eine schematische Übersicht über Komponenten eines alternativen Ausführungsbeispiels eines erfindungsgemäßen Fortbewegungsmittels mit einem alternativen Ausführungsbeispiel einer erfindungsgemäßen Anwenderschnittstelle;
- Figur 7: eine geschnittene, perspektivische Ansicht eines weiteren Ausführungsbeispiels einer erfindungsgemäßen Anwenderschnittstelle; und
- Figur 8: eine geschnittene, perspektivische Ansicht eines weiteren Ausführungsbeispiels einer erfindungsgemäßen Anwenderschnittstelle.

### Ausführungsformen der Erfindung

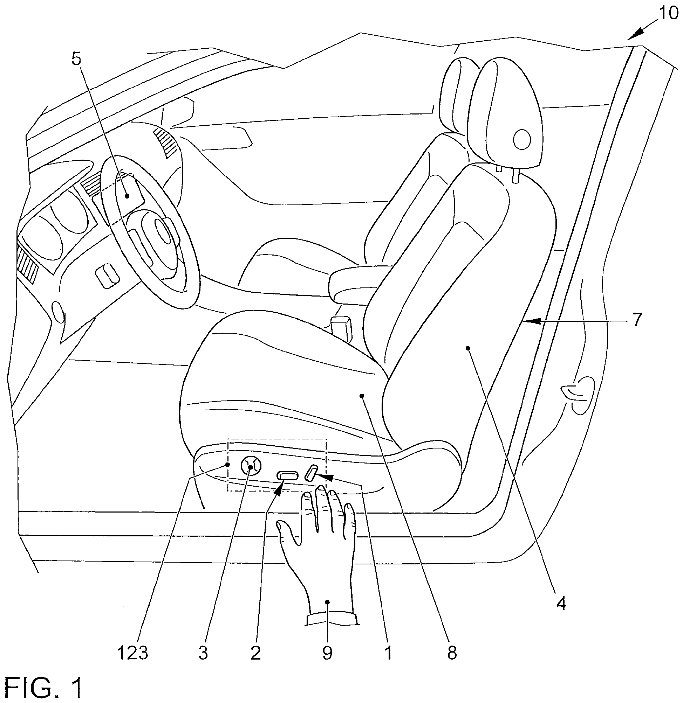

Figur 1 zeigt den Innenraum eines Pkws 10 als Fortbewegungsmittel, in welchem ein erstes Schalterfeld 123 zur Bedienung einer elektromotorischen Verstellung des Fahrersitzes 7 als elektromotorisch verstellbares Teil des Pkws 10 dargestellt sind. Ein erster Schalter 1 des ersten Schalterfeldes 123 ist einer Verstellung einer Neigung der Sitzlehne 4 zugeordnet. Ein zweiter Schalter 2 des ersten Schalterfeldes 123 ist einer Verstellung einer Position der Sitzfläche 8 des Fahrersitzes zugeordnet. Ein dritter Schalter 3 des ersten Schalterfeldes 123 ist einer Verstellung einer Lordosenstütze (nicht dargestellt) des Fahrersitzes 7 zugeordnet. Eine Annäherung durch eine Hand 9 eines Anwenders an das erste Schalterfeld 123 wird durch eine (nicht dargestellte) kapazitive Annäherungssensorik innerhalb der ersten Schalter 123 erkannt, im Ansprechen worauf ein der Sitzverstellung zugeordneter Hinweis auf einem zentralen Informationsdisplay als Bildschirm 5 des Pkws 10 angezeigt wird.

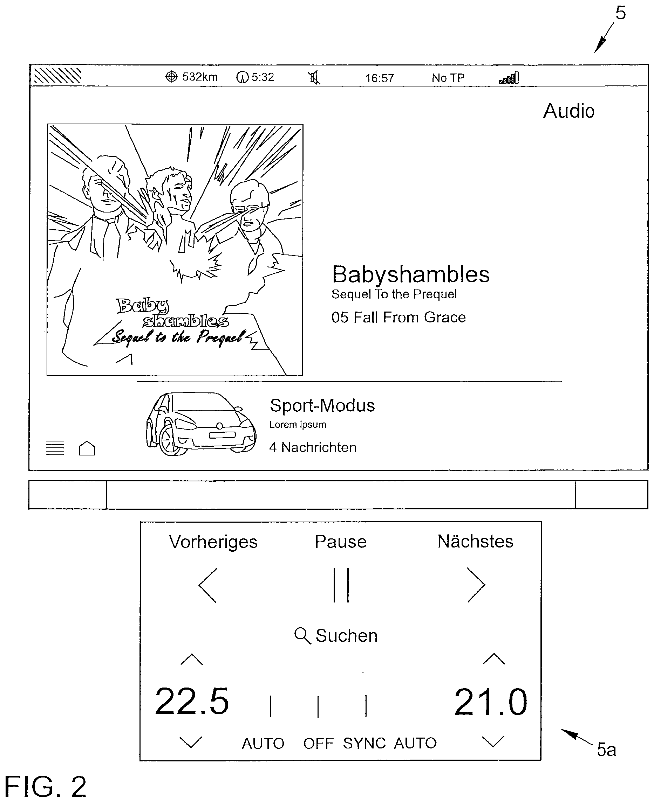

Figur 2 zeigt einen Bildschirminhalt des Bildschirms 5 vor dem Erkennen einer Annäherung an das erste Schalterfeld (Bezugszeichen 123 in Figur 1). Der Bildschirminhalt stellt Informationen bezüglich einer aktuellen Audiowiedergabe dar. Zudem sind ein Fahrwerksmodus und das Vorhandensein ungelesener Nachrichten in Textform vorgesehen. Unterhalb des Bildschirms 5 ist ein kleinerer Anzeigebereich 5a zur Bedienung der Audiowiedergabe und Klimaeinstellungen vorgesehen. Diese Elemente des Bildschirminhaltes haben keinen inhaltlichen Bezug zu den Funktionen des Schalterfeldes zur Bedienung einer elektromotorischen Verstellung des Fahrersitzes.

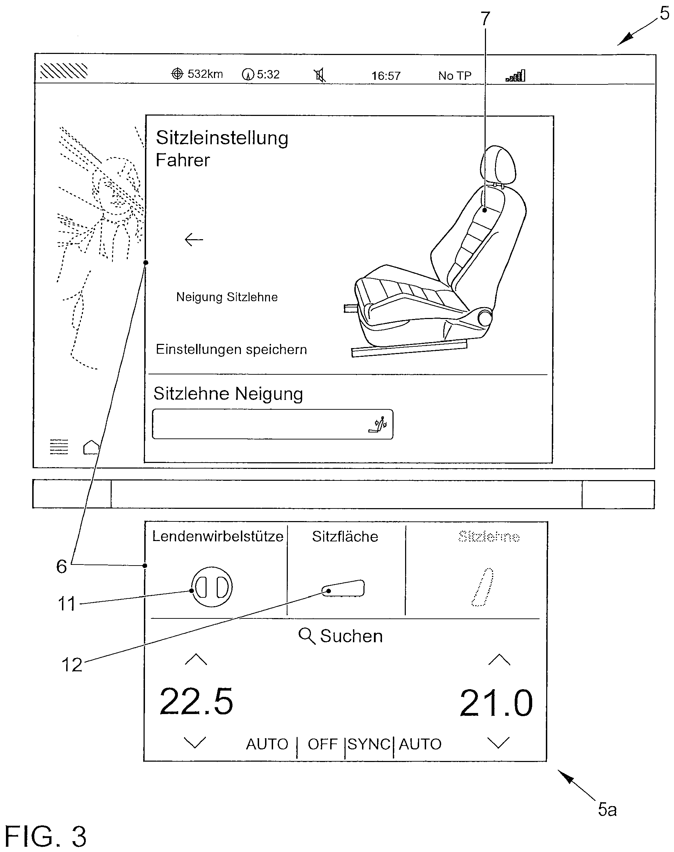

Figur 3 zeigt die in Figur 2 dargestellte Bildschirmansicht nach einer erfolgreichen Erkennung einer Annäherung einer Hand eines Anwenders an das erste Schalterfeld (Bezugszeichen 123 in Figur 1). Die Annäherung führt erfindungsgemäß dazu, dass ein Hinweis 6 sowohl auf dem zentralen Informationsdisplay 5 als auch auf dem kleineren Anzeigebereich 5a angezeigt wird, welcher den Anwender über die denjenigen Schaltelementen, welchen er sich soeben angenähert hat, zugeordnete Funktionen informiert. Hierzu ist ein Sinnbild für einen Fahrersitz 7 dargestellt. Zudem wird in Textform darauf hingewiesen, dass eine Betätigung des aktuell angenäherten ersten Schalters die Neigung der Sitzlehne beeinflusst. Zudem wird angeboten, die aktuellen Einstellungen zu speichern. Auch in dem kleineren Anzeigebereich wird im Ansprechen auf die Annäherung ein Hinweis zur Sitzeinstellung ausgegeben. Unterschiedliche Schaltflächen 11, 12 ermöglichen eine berührende Eingabe zur Anpassung der Lendenwirbelstütze bzw. der Sitzfläche.

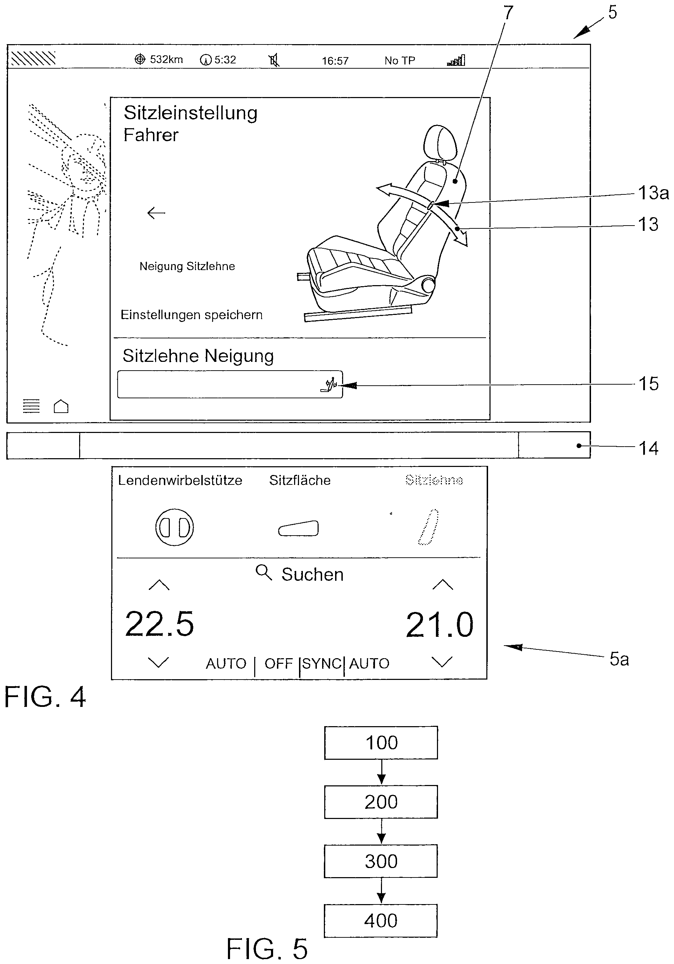

Figur 4 zeigt eine alternative Darstellung für den Hinweis 6 (s. Figur 3), in welchem der Rückenlehne des Fahrersitzes 7 ein Schiebereglerelement 13 überlagert dargestellt ist. Auch dieses kann gemäß einem Ausführungsbeispiel der vorliegenden Erfindung im Ansprechen auf eine Annäherung der Hand des Anwenders an einem der Sitzlehne zugeordneten ersten Schalter angezeigt und anschließend über die berührungsempfindliche Oberfläche des zentralen Bildschirms 5 bedient werden. Entweder kann der Anwender eine Position auf dem Schieberegler 13 antippen, im Ansprechen worauf die gewählte Position automatisch elektromotorisch realisiert wird. Anderenfalls ergreift der Anwender einen Indikator 13a für eine aktuelle Position der Rückenlehne und verschiebt diesen an eine gewünschte Position des Schiebereglers 13. Im Ansprechen darauf wird die jeweilige Position des Indikators 13a auch für die Rückenlehne des Fahrersitzes 7 schnellstmöglich realisiert. Zwischen dem zentralen Informationsdisplay 5 und dem kleineren Anzeigebereich 5a ist ein horizontal angeordneter kapazitiver Slider 14 angeordnet, über welchen eine redundante Eingabe zur Anpassung einer innerhalb des Hinweises aktivierten Komponente des elektromotorisch verstellbaren Sitzes vorgenommen werden kann. Ein Hinweis 15 auf dem zentralen Informationsdisplay 5 zeigt an, auf welche Komponente sich die Eingaben über den kapazitiven Slider 14 beziehen.

Figur 5 zeigt Schritte eines Ausführungsbeispiels eines erfindungsgemäßen Verfahrens zur Unterstützung eines Anwenders vor einer Bedienung eines Schalters zur elektromotorischen Verstellung eines Teils eines Fortbewegungsmittels. In Schritt 100 wird eine Annäherung des Anwenders an einen ersten Schalter erkannt. Im Ansprechen darauf wird in Schritt 200 ein Hinweis zu einer dem ersten Schalter zugeordneten Funktion auf einem Bildschirm dargestellt. Der Hinweis umfasst auch Schaltflächen zur Entgegennahme von Anwendereingaben. In Schritt 300 wird eine Eingabe bezüglich einer Schaltfläche des Hinweises mittels einer dem Bildschirm zugeordneten Erfassungseinrichtung in Form einer berührungsempfindlichen Oberfläche erfasst. In Schritt 400 wird ein der Eingabe zugeordneter Steuerbefehl an einen Elektromotor zur Verstellung des elektromotorisch verstellbaren Teils ausgegeben. Währenddessen kann sich der Anwender wieder vollständig seiner Fahraufgabe widmen, wodurch die Verkehrssicherheit geringstmöglich durch das erfindungsgemäße Verfahren beeinträchtigt wird.

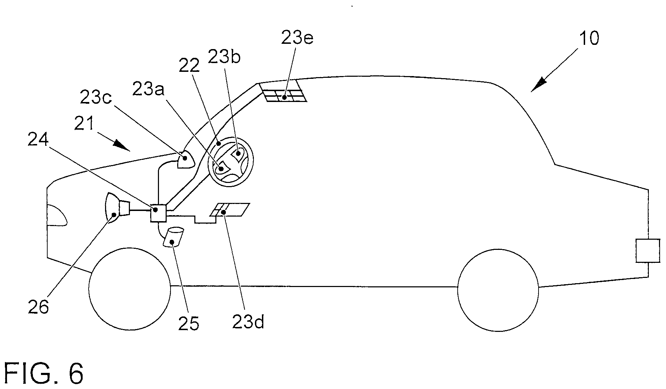

Figur 6 zeigt einen Pkw 10 als Fortbewegungsmittel, welcher eine Anwenderschnittstelle 21 mit fünf jeweils erfindungsgemäß ausgestalteten Schaltereinheiten aufweist. Die dauerhaft opaken Abdeckungen 23a, 23b, 23c, 23d, 23e der Schaltereinheiten sind zwei Seiten eines Lenkrades 22 sowie einem Spiegeldreieck, einem Fensterheberbedienmodul in einer (nicht dargestellten) Tür sowie einem Dachbedienmodul zur Steuerung eines Schiebedachs und einer Innenraumbeleuchtung zugeordnet. Die Einheiten sind mit einem gemeinsamen elektronischen Steuergerät 24 als Ausführungsbeispiel einer Auswerteeinheit informationstechnisch verbunden, welches zusätzlich eine Datenverbindung zu einem Datenspeicher 25 aufweist. Im Datenspeicher 25 sind beispielsweise Referenzen für vordefinierte Anwendergesten und Kraftwirkungsschwellwerte hinterlegt. Schließlich ist auch ein Lautsprecher 26 vorgesehen, welcher zur akustischen Rückmeldung an den Anwender lediglich symbolisch beispielhaft außerhalb der Abdeckungen 23a, 23b, 23c, 23d, 23e dargestellt ist.

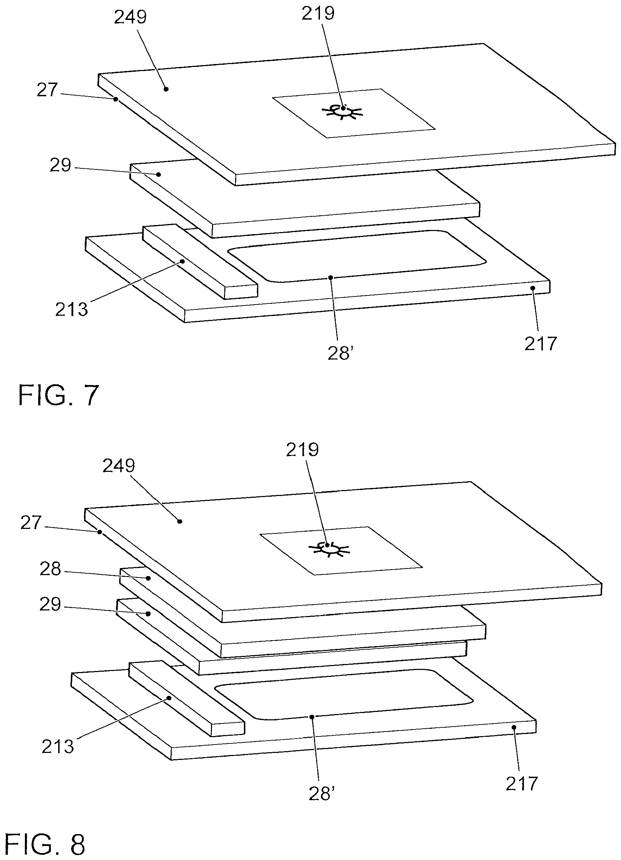

Figur 7 zeigt eine perspektivische Darstellung eines schematischen Aufbaus eines Teils einer erfindungsgemäßen Anwenderschnittstelle 21 in Form eines Teils, welcher den elektrischen Schalter 1, 2, 3 in Fig. 1 abdeckt. Bei diesem ist die Abdeckung 249 durch eine lichtundurchlässige, schwarze Lackschicht 27 opak gestaltet ist. Das Symbol 219 ist ein durch Gravuren im Lack hergestellter transluzenter Bereich. Ein Lichtleiter 29 ist zur Leitung aus einem LED-Leuchtmittel 213 ausgeschütteten Lichtes an die Abdeckung 249 vorgesehen. Auf der Platine 217 ist eine kapazitive Sensorik 28' zur Erkennung von Annäherung, Berührungen und Wischgesten angeordnet.

Figur 8 zeigt die in Figur 7 dargestellte Anordnung, bei welcher eine kapazitive Folie 28 zwischen dem Oberflächenbereich 249 und dem Lichtleiter 29 zur Erkennung von Berührungen vorgesehen wurde. Unterhalb der Lackschicht 27 ist eine kapazitive Folie zur Erzeugung der berührungsempfindlichen Eigenschaft der Anwenderschnittstelle vorgesehen. Sie reagiert entsprechend der in Figur 7 auf der Platine 217 angeordneten kapazitiven Sensorik 28' auf menschliches Gewebe, dient zur Erkennung von Annäherung, Berührungen und Wischgesten und leitet entsprechende Steuerbefehle an eine (nicht dargestellte) Auswerteeinheit. Die in Figur 7 eingeführte Sensorik 28' ist auf der Platine 217 weiterhin zur Sensorik für Annährung und zur Gestenerkennung vorgesehen.

Auch wenn die erfindungsgemäßen Aspekte und vorteilhaften Ausführungsformen anhand der in Verbindung mit den beigefügten Zeichnungsfiguren erläuterten Ausführungsbeispiele im Detail beschrieben worden sind, sind für den Fachmann Modifikationen und Kombinationen von Merkmalen der dargestellten Ausführungsbeispiele möglich, ohne den Bereich der vorliegenden Erfindung zu verlassen, deren Schutzbereich durch die beigefügten Ansprüche definiert wird.

### Bezugszeichenliste

- 1: Schalter für Sitzlehneneinstellung
- 2: Schalter für Sitzflächeneinstellung
- 3: Schalter für Lordosenstütze
- 4: Rückenlehne
- 5: Bildschirm, zentrales Informationsdisplay
- 5 a: Anzeigebereich
- 6: Hinweis
- 7: Fahrersitz
- 8: Sitzfläche
- 9: Hand des Anwenders
- 10: Pkw
- 11, 12: Schaltflächen zur Auswahl des elektromotorisch verstellbaren Teils
- 13: Slider
- 13 a: Indikator (Sliderposition)
- 14: kapazitiver Slider
- 15: Indikator zur dem Slider 14 zugeordneten Funktion
- 21: Anwenderschnittstelle
- 22: Lenkrad
- 23a, 23b, 23c, 23d: Abdeckungen
- 24: Steuergerät
- 25: Datenspeicher
- 26: Lautsprecher
- 27: Lackschicht
- 28: kapazitive Folie
- 28': kapazitive Sensorik
- 29: Lichtleiter
- 100: Verfahrensschritt
- 123: Schalterfeld
- 200: Verfahrensschritt
- 219: Symbol
- 213: LED-Leuchtmittel
- 249: Abdeckung
- 300, 400: Verfahrensschritte

## Patentansprüche

1. Verfahren zur Unterstützung eines Anwenders vor einer Bedienung eines Schalters (1, 2, 3) zur elektromotorischen Verstellung eines Teils (4) eines Fortbewegungsmittels (10) umfassend die Schritte:
- Erkennen (100) einer Annäherung des Anwenders an einen ersten Schalter (1, 2, 3) und im Ansprechen darauf
- Anzeigen (200) eines Hinweises (6) zu einer dem ersten Schalter (1, 2, 3) zugeordneten Funktion, weiter umfassend:
Erkennen einer
- unter Kontakt mit einer Oberfläche des Schalters (1, 2, 3) und/oder
- in einem Erfassungsbereich vor dem Schalter (1, 2, 3) ausgeführten Anwendergeste, und im Ansprechen darauf
- Ausgeben (400) eines der Eingabe zugeordneten Steuerbefehls an einen Elektromotor zur Verstellung des Teils (4).

2. Verfahren nach Anspruch 1, wobei die Funktion
- eine Sitzverstellung und/oder
- eine Spiegelverstellung und/oder
- eine Schiebedachverstellung und/oder
- eine Verstellung eines Sonnenrollos
ist.

3. Verfahren nach Anspruch 1 oder 2, wobei der Hinweis (6)
- auf einem Bildschirm (5) ausgegeben oder
- durch ein am ersten Schalter (1, 2, 3) angeordnetes Leuchtmittel (213) erzeugt wird.

4. Verfahren nach einem der vorstehenden Ansprüche, wobei der Hinweis (6)
- eine Abbildung
- eines Sitzes (7) und/oder
- eines Spiegels und/oder
- eines Schiebedachs und/oder
- eines Sonnenrollos umfasst und/oder
- eine dem Schalter (1, 2, 3) zugeordnete Funktion des Teils (4) kenntlich macht.

5. Verfahren nach einem der vorstehenden Ansprüche, wobei der Hinweis (6) auf einem Bildschirm (5) ausgegeben wird, und wobei das Verfahren weiter umfasst
- Erfassen (300) einer Eingabe bezüglich des Hinweises (6) mittels einer dem Bildschirm (5) zugeordneten Erfassungseinrichtung und
- Ausgeben (400) eines der Eingabe zugeordneten Steuerbefehls an einen Elektromotor zur Verstellung des Teils (4).

6. Vorrichtung umfassend
- einen ersten Schalter (1), welcher zur elektromotorischen Verstellung eines ersten Teils (4) eines Fortbewegungsmittels (10) vorgesehen ist, und
- eine erste Annäherungssensorik (28, 28'), welche eingerichtet ist,
- eine Annäherung eines Anwenders an den ersten Schalter (1) zu erkennen, und im Ansprechen darauf
- ein Signal zum Anzeigen eines Hinweises (6) zu einer dem ersten Schalter (1, 2, 3) zugeordneten Funktion zu senden, weiter umfassend:
- eine Eingabeeinrichtung (28, 28') zur Erkennung einer
- unter Kontakt mit einer Oberfläche des ersten Schalters (1, 2, 3) und/oder
- in einem Erfassungsbereich vor dem ersten Schalter (1, 2, 3) ausgeführten Anwendergeste, und
- eine Auswerteeinheit (24), wobei die Auswerteeinheit (24) eingerichtet ist,
- im Ansprechen auf eine vordefinierte Anwendergeste einen der Eingabe zugeordneten Steuerbefehl an einen Elektromotor zur Verstellung des Teils (4) auszugeben.

7. Vorrichtung nach Anspruch 6 weiter umfassend
- einen zweiten Schalter (2), welcher zur elektromotorischen Verstellung eines zweiten Teils (8) des Fortbewegungsmittels (10) vorgesehen ist, und
- eine zweite Annäherungssensorik, welche eingerichtet ist,
- eine Annäherung eines Anwenders an den zweiten Schalter (2) zu erkennen, und im Ansprechen darauf
- ein Signal zum Anzeigen eines Hinweises (6) zu einer dem zweiten Schalter zugeordneten Funktion zu senden.

8. Vorrichtung nach einem der Ansprüche 6 oder 7 weiter umfassend
- ein Leuchtmittel (213) und
- eine über dem ersten Schalter (1) oder neben dem ersten Schalter (1) angeordnete Blende (27), wobei
- die Blende (27) einen in Form eines Piktogramms (219) geformten transluzenten Bereich aufweist und
- das Leuchtmittel (213) eingerichtet ist, im Ansprechen auf ein Steuersignal der ersten Annäherungssensorik (28, 28') Licht durch die Blende (27) auszuschütten.

9. Vorrichtung nach einem der Ansprüche 6 bis 8 weiter umfassend
- einen Bildschirm (5) zur Anzeige des Hinweises (6) und
- eine dem Bildschirm (5) zugeordnete berührungsempfindliche Oberfläche, welche eingerichtet ist, im Ansprechen auf eine Betätigung eines auf dem Bildschirm (5) dargestellten Bedienelementes (11) einen Steuerbefehl zur Herstellung einer mit dem Steuerbefehl korrespondierenden Position des Teils (4) zu veranlassen.

10. Vorrichtung nach einem der Ansprüche 6 bis 9 oder Verfahren nach einem der vorstehenden Ansprüche 1 bis 5, wobei der erste Schalter (1) und/oder der zweite Schalter (2) zur Montage
- an einem Sitz (4, 8) und/oder
- an einem Spiegeldreieck und/oder
- an einem Dachmodul zur Bedienung eines Schiebedachs des Fortbewegungsmittels (10) vorgesehen ist bzw. sind.

11. Vorrichtung nach einem der vorstehenden Ansprüche 6 bis 10, wobei die Annäherungssensorik einen
- kapazitiven Sensor und/oder
- optischen Sensor und/oder
- Ultraschallsensor
umfasst.

12. Fortbewegungsmittel umfassend eine Vorrichtung nach einem der vorstehenden Ansprüche 6 bis 11.

## Claims

1. A method for supporting a user before operation of a switch (1, 2, 3) for electromotive adjustment of a part (4) of a means of locomotion (10) comprising the steps:
- Detection (100) of an approach of the user to a first switch (1, 2, 3) and in response thereto
- display (200) of an indication (6) with regard to a function associated with the first switch (1, 2, 3), further comprising:
Detection of a user gesture carried out
- under contact with a surface of the switch (1, 2, 3) and/or
- in a detection region in front of the switch (1, 2, 3)
and in response thereto
- output (400) of a control command associated with the input to an electric motor for adjustment of the part (4).

2. The method according to Claim 1, wherein the function is
- a seat adjustment and/or
- a mirror adjustment and/or
- a sliding roof adjustment and/or
- an adjustment of a sun blind.

3. The method according 1 or 2, wherein the indication (6)
- is output on a screen (5) or
- is generated by a lighting means (213) arranged on the first switch (1, 2, 3).

4. The method according to any one of the preceding claims, wherein the indication (6) comprises
- an image
- of a seat (7) and/or
- of a mirror and/or
- of a sliding roof and/or
- of a sun blind and/or
- indicates a function of the part (4) associated with the switch (1, 2, 3).

5. The method according to any one of the preceding claims, wherein the indication (6) is output on a screen (5), and wherein the method further comprises:
- Detection (300) of an input with regard to the indication (6) by means of a detecting device associated with the screen (5) and
- output (400) of a control command associated with the input to an electric motor for adjustment of the part (4).

6. An apparatus comprising
- a first switch (1), which is provided for the electromotive adjustment of a first part (4) of a means of locomotion (10), and
- a first approach sensor system (28, 28'), which is configured,
- to detect an approach of a user to the first switch (1), and in response thereto
- to send a signal for the display of an indication (6) with regard to a function associated with the first switch (1, 2, 3), further comprising:
- an input device (28, 28') for detecting a user gesture carried out
- under contact with a surface of the first switch (1, 2, 3) and/or
- in a detection region in front of the first switch (1, 2, 3), and
- an evaluation unit (24), wherein the evaluation unit (24) is configured,
- in response to a pre-defined user gesture to output a control command associated with the input to an electric motor for adjustment of the part (4).

7. The apparatus according to Claim 6 further comprising
- a second switch (2), which is provided for the electromotive adjustment of a second part (8) of the means of locomotion (10), and
- a second approach sensor system, which is configured
- to detect an approach of a user to the second switch (2), and in response thereto
- to send a signal for the display of an indication (6) with regard to a function associated with the second switch.

8. The apparatus according to any one of Claims 6 or 7 further comprising
- a lighting means (213) and
- an aperture (27) arranged over the first switch (1) or next to the first switch (1), wherein
- the aperture (27) has a translucent region formed in the form of a pictogram (219) and
- the lighting means (213) is configured, in response to a control signal of the first approach sensor system (28, 28') to distribute light through the aperture (27).

9. The apparatus according to any one of Claims 6 to 8 further comprising
- a screen (5) for the display of the indication (6) and
- a touch-sensitive surface associated with the screen (5), which is configured, in response to an activation of a control element (11) displayed on the screen (5) to make a control command to establish a position of the part (4) corresponding with the control command.

10. The apparatus according to any one of Claims 6 to 9 or the method according to any one of the preceding claims 1 to 5, wherein the first switch (1) and/or the second switch (2) is or are provided for mounting
- on a seat (4, 8) and/or
- on a mirror triangle and/or
- on a roof module for operating a sliding roof of the means of locomotion (10).

11. The apparatus according to any one of the preceding Claims 6 to 10, wherein the approach sensor system comprises a
- capacitive sensor and/or
- optical sensor and/or
- ultrasonic sensor.

12. The means of locomotion comprising an apparatus according to any one of the preceding Claims 6 to 11.

## Revendications

1. Procédé d'assistance à un utilisateur avant une manipulation d'un commutateur (1, 2, 3) pour le réglage par moteur électrique d'une partie (4) d'un moyen de locomotion (10), comprenant les étapes :
- identification (100) d'une approche de l'utilisateur vers un premier commutateur (1, 2, 3) et, en réaction à cela,
- affichage (200) d'une instruction (6) concernant une fonction affectée au premier commutateur (1, 2, 3), comprenant également :
identification
d'un geste d'utilisateur effectué
- en contact avec une surface du commutateur (1, 2, 3) et/ou
- dans une zone de détection devant le commutateur (1, 2, 3) et en réaction à cela
- délivrance (400) d'un ordre de commande affecté à l'entrée en direction d'un moteur électrique pour le réglage de la partie (4) .

2. Procédé selon la revendication 1, dans lequel la fonction est
- un réglage de siège et/ou
- un réglage de rétroviseur et/ou
- un réglage de toit ouvrant et/ou
- un réglage d'un store.

3. Procédé selon la revendication 1 ou 2, dans lequel l'instruction (6)
- est délivrée sur un écran (5) ou
est produite
- par un moyen lumineux (213) disposé sur le premier commutateur (1, 2, 3).

4. Procédé selon l'une des revendications précédentes, dans lequel l'instruction (6) comprend une reproduction
- d'un siège (7) et/ou
- d'un rétroviseur et/ou
- d'un toit ouvrant et/ou
- d'un store et/ou
montre
- une fonction de la partie (4) affectée au commutateur (1, 2, 3) .

5. Procédé selon l'une des revendications précédentes, dans lequel l'instruction (6) est délivrée sur un écran (5), et dans lequel le procédé comprend également
- la détection (300) d'une entrée concernant l'instruction (6) au moyen d'un équipement de détection affecté à l'écran (5) et
- la délivrance (400) d'un ordre de commande affecté à l'entrée en direction d'un moteur électrique pour le réglage de la partie (4) .

6. Dispositif, comprenant
- un premier commutateur (1) qui est prévu pour le réglage par moteur électrique d'une première partie (4) d'un moyen de locomotion (10), et
- des premiers détecteurs de proximité (28, 28') qui sont agencés
- pour identifier une approche d'un utilisateur vers le premier commutateur (1) et, en réaction à cela,
- pour envoyer un signal pour l'indication d'une instruction (6) concernant une fonction affectée au premier commutateur (1, 2, 3), comprenant également :
- un équipement d'entrée (28, 28') pour la reconnaissance d'un geste d'utilisateur effectué
- en contact avec une surface du premier commutateur (1, 2, 3) et/ou
- dans une zone de détection devant le premier commutateur (1, 2, 3), et
- une unité d'analyse (24), dans lequel l'unité d'analyse (24) est agencée
- pour, en réaction à un geste d'utilisateur prédéfini, délivrer un ordre de commande affecté à l'entrée en direction d'un moteur électrique pour le réglage de la partie (4).

7. Dispositif selon la revendication 6, comprenant également
- un deuxième commutateur (2) qui est prévu pour le réglage par moteur électrique d'une deuxième partie (8) du moyen de locomotion (10), et
- des deuxièmes détecteurs de proximité qui sont agencés
- pour identifier une approche d'un utilisateur vers le deuxième commutateur (2) et, en réaction à cela,
- pour envoyer un signal pour l'indication d'une instruction (6) concernant une fonction affectée au deuxième commutateur.

8. Dispositif selon l'une des revendications 6 ou 7, comprenant également
- un moyen d'éclairage (213) et
- un bandeau (27) disposé au-dessus du premier commutateur (1) ou près du premier commutateur (1), dans lequel
- le bandeau (27) comporte une zone translucide formée en forme de pictogramme (219) et
- le moyen lumineux (213) est agencé pour, en réaction à un signal de commande des premiers détecteurs de proximité (28, 28'), distribuer de la lumière à travers le bandeau (27).

9. Dispositif selon l'une des revendications 6 à 8, comprenant également
- un écran (5) destiné à l'affichage de l'instruction (6) et
- une surface tactile affectée à l'écran (5) qui est agencée pour, en réaction à un actionnement d'un élément de manoeuvre (11) représenté sur l'écran (5), provoquer un ordre de commande pour l'établissement d'une position de la partie (4) correspondant à l'ordre de commande.

10. Dispositif selon l'une des revendications 6 à 9 ou procédé selon l'une des revendications précédentes 1 à 5, dans lequel le premier commutateur (1) et/ou le deuxième commutateur (2) est ou respectivement sont prévu(s) pour le montage
- sur un siège (4, 8) et/ou
- sur un triangle de rétroviseur et/ou
- sur un module de toit pour la manoeuvre d'un toit coulissant du moyen de locomotion (10).

11. Dispositif selon l'une des revendications précédentes 6 à 10, dans lequel les détecteurs de proximité comprennent
- un capteur capacitif et/ou
- un capteur optique et/ou
- un capteur à ultrasons.

12. Moyen de locomotion (10), comprenant un dispositif selon l'une des revendications précédentes 6 à 11.
